# EUROPEAN PATENT APPLICATION

(11) **EP 4 379 999 A2**
(43) Date of publication of application: **05.06.2024**
(21) Application number: 23209600.8
(22) Date of filing: 14.11.2023
(51) Int. Cl.: H02J 7/00

(54) **LITHIUM BATTERY POWER SUPPLY CONNECTION RELATION DETECTION CIRCUIT**

(30) Priority: 30.11.2022 CN 202211524986
(71) Applicant: Zhangzhou Kehua Electric Technology Co., Ltd, Zhangzhou Fujian 363000 (CN)
(72) Inventor: YANG, Xin, Zhangzhou, 363000 (CN); ZHANG, Baosen, Zhangzhou, 363000 (CN); CHEN, Yangyuan, Zhangzhou, 363000 (CN)
(74) Representative: Isarpatent

(57) **Abstract**

The present application provides a lithium battery power supply connection relation detection circuit, a first power supply and a second power supply are connected in series or in parallel to form a power supply system; the detection circuit is configured for detecting a series-parallel relationship between the first power supply and the second power supply; the detection circuit includes a voltage acquisition module, a voltage detection module and a main control module; a first input end of the voltage acquisition module is connectable with a negative electrode of the first power supply, a second input end of the voltage acquisition module is connectable with a negative electrode of the second power supply, and an output end of the voltage acquisition module is connected with an input end of the voltage detection module; an output end of the voltage detection module is connected with the main control module; and the main control module is configured for receiving a detection signal output by the output end of the voltage detection module and determining the series-parallel relationship between the first power supply and the second power supply based on the detection signal. In the present application, the voltage difference between the negative electrodes of two power supplies is detected, and the series-parallel relationship between the two power supplies is determined based on the voltage difference, the circuit structure is simple and the detection is fast.

## Description

### TECHNICAL FIELD

The present application relates to the technical field of power supply, and particularly relates to a lithium battery power supply connection relation detection circuit.

### BACKGROUND

Lithium batteries are widely used in various fields due to their high energy density, high power, and long cycle life. Lithium battery power supply is powered by lithium batteries, which are used to provide energy for electrical devices. To meet different electricity needs, multiple lithium battery power supplies can be connected in series or in parallel to meet different electricity needs.

In the prior art, without knowing the output voltage of the power system formed by the lithium battery power supplies, it is not possible to quickly detect whether two lithium battery power supplies are connected in series or in parallel relationship.

### SUMMARY

The present application provides a lithium battery power supply connection relation detection circuit to solve the problem of lacking an effective technical means for detecting the series or parallel connection relationship of the lithium battery power supply in the prior art.

Embodiments of the present application provides a lithium battery power supply connection relation detection circuit, where a first power supply and a second power supply are connected in series or in parallel to form a power supply system; the detection circuit is configured for detecting a series-parallel relationship between the first power supply and the second power supply; and the series-parallel relationship between the first power supply and the second power supply is switchable;
where the detection circuit includes a voltage acquisition module, a voltage detection module and a main control module;
a first input end of the voltage acquisition module is connectable with a negative electrode of the first power supply, a second input end of the voltage acquisition module is connectable with a negative electrode of the second power supply, and an output end of the voltage acquisition module is connected with an input end of the voltage detection module;
an output end of the voltage detection module is connected with the main control module; and
the main control module is configured for receiving a detection signal output by the output end of the voltage detection module and determining the series-parallel relationship between the first power supply and the second power supply based on the detection signal.

In one embodiment, the input end of the voltage detection module includes a first voltage input end and a second voltage input end; the first voltage input end is connected with the output end of the voltage acquisition module, and the second voltage input end is connected with the second input end of the voltage acquisition module;
the voltage acquisition module includes a first resistor and a second resistor;
a first end of the first resistor is connected with the first input end of the voltage acquisition module, and a second end of the first resistor is respectively connected with a first end of the second resistor and the output end of the voltage acquisition module; and
a second end of the second resistor is connected with the second input end of the voltage acquisition module.

In one embodiment, the voltage detection module includes an optical coupler, a third resistor, a fourth resistor, a fifth resistor and a sixth resistor;
a positive input end of the optical coupler is respectively connected with a first end of the third resistor and a first end of the fourth resistor, a negative input end of the optical coupler is respectively connected with a second end of the fourth resistor and a first end of the fifth resistor, a positive output end of the optical coupler is respectively connected with a first end of the sixth resistor and the output end of the voltage detection module, and a negative output end of the optical coupler is grounded;
a second end of the third resistor is connected with the first voltage input end of the voltage detection module;
a second end of the fifth resistor is connected with the second voltage input end of the voltage detection module; and
a second end of the sixth resistor is connected with a DC power supply.

In one embodiment, the voltage detection module further includes a zener diode;
a cathode of the zener diode is connected with the positive input end of the optical coupler, and an anode of the zener diode is connected with the negative input end of the optical coupler.

In one embodiment, the voltage detection module further includes a first capacitor and a second capacitor;
the first capacitor is connected in parallel with the fourth resistor; and
a first end of the second capacitor is connected with the positive output end of the optical coupler, and a second end of the second capacitor is grounded.

In one embodiment, the power supply system further includes two series-parallel short-circuit rows;
a positive electrode of the first power supply is connected with a positive output end of the power supply system, and the negative electrode of the first power supply is connected with a neutral end of the power supply system;
a positive electrode of the second power supply is vacant, and the negative electrode of the second power supply is connected with a negative output end of the power supply system; and
where one series-parallel short-circuit row is overlapped between the negative electrode of the first power supply and the positive electrode of the second power supply, and the first power supply and the second power supply are connected in series; or
one series-parallel short-circuit row is overlapped between the positive electrode of the first power supply and the positive electrode of the second power supply, the other series-parallel short-circuit row is overlapped between the negative electrode of the first power supply and the negative electrode of the second power supply, and the first power supply and the second power supply are connected in parallel.

In one embodiment, the power supply system further includes a first connection line, a second connection line, a third connection line and a fourth connection line;
the positive electrode of the first power supply is connected with the positive output end of the power supply system through the first connection line;
the positive electrode of the second power supply is connected with the second connection line;
the negative electrode of the first power supply is connected with the neutral end of the power supply system through the third connection line;
the negative electrode of the second power supply is connected with the negative output end of the power supply system through the fourth connection line; and
where one series-parallel short-circuit row is overlapped between the second connection line and the third connection line, and the first power supply and the second power supply are connected in series; or
one series-parallel short-circuit row is overlapped between the first connection line and the second connection line, the other series-parallel short-circuit row is overlapped between the third connection line and the fourth connection line, and the first power supply and the second power supply are connected in parallel.

In one embodiment, a number of the first power supply is at least one, a number of the second power supply is at least one, and the number of the first power supply is the same as the number of the second power supply;
the positive electrode of each first power supply is connected with the first connection line, and the negative electrode of each first power supply is connected with the third connection line;
the positive electrode of each second power supply is connected with the second connection line, and the negative electrode of each second power supply is connected with the fourth connection line; and
where one series-parallel short-circuit row is overlapped between the second connection line and the third connection line, and each first power supply is connected in series with corresponding second power supply, respectively; or
one series-parallel short-circuit row is overlapped between the first connection line and the second connection line, the other series-parallel short-circuit row is overlapped between the third connection line and the fourth connection line, and each first power supply is connected in parallel with corresponding second power supply, respectively.

In one embodiment, the first connection line, the second connection line, the third connection line and the fourth connection line are arranged side by side in sequence.

Embodiments of the present application provides a lithium battery power supply connection relation detection circuit, where a first power supply and a second power supply are connected in series or in parallel to form a power supply system; the detection circuit is configured for detecting a series-parallel relationship between the first power supply and the second power supply; and the series-parallel relationship between the first power supply and the second power supply is switchable; the detection circuit includes a voltage acquisition module, a voltage detection module and a main control module; a first input end of the voltage acquisition module is connectable with a negative electrode of the first power supply, a second input end of the voltage acquisition module is connectable with a negative electrode of the second power supply, and an output end of the voltage acquisition module is connected with an input end of the voltage detection module; and the main control module is configured for receiving a detection signal output by the output end of the voltage detection module and determining the series-parallel relationship between the first power supply and the second power supply based on the detection signal. In the embodiments of the present application, the voltage acquisition module obtains the voltage difference between the negative electrodes of two power supplies, and the voltage detection module converts the voltage difference into a detection signal and sends it to the main control module; finally, the main control module determines the series-parallel relationship between the two power supplies based on the detection signal. The circuit structure is simple and the detection is fast.

### BRIEF DESCRIPTION OF THE DRAWINGS

In order to provide a clearer explanation of the technical solution in the embodiments of the present application, a brief introduction will be given to the drawings required in the description of embodiments or prior art. It is evident that the drawings in the following description are only some embodiments of the present application. For ordinary technical personnel in the art, other drawings can be obtained based on these drawings without any creative labor.
Fig. 1 is a schematic circuit structure diagram of a lithium battery power supply connection relationship detection circuit provided by one embodiment of the present application;
Fig. 2 is a circuit principle diagram of a voltage acquisition module provided by one embodiment of the present application;
Fig. 3 is a circuit principle diagram of a voltage detection module provided by one embodiment of the present application;
Fig. 4 is a schematic diagram of a power supply system in which a first power supply and a second power supply are connected in series provided by one embodiment of the present application;
Fig. 5 is a schematic diagram of a power supply system in which a first power supply and a second power supply are connected in parallel provided by one embodiment of the present application;
Fig. 6 is a schematic diagram of a power supply system in which a first power supply and a second power supply are connected in series provided by another one embodiment of the present application; and
Fig. 7 is a schematic diagram of a power supply system in which a first power supply and a second power supply are connected in parallel provided by another one embodiment of the present application.

### DETAILED DESCRIPTION OF ILLUSTRATIVE EMBODIMENTS

In the following description, specific details such as specific system structures and technologies are provided for the purpose of illustration rather than limitation, so as to provide a thorough understanding of the embodiments of the present application. However, it will be apparent to those skilled in the art that the present application may be practiced in other embodiments without these specific details. In other instances, detailed descriptions of well-known systems, devices, circuits, and methods are omitted so as not to obscure the present application in unnecessary detail.

In order to make the purpose, technical solutions and advantages of the present application clearer, specific embodiments will be described below in conjunction with the drawings.

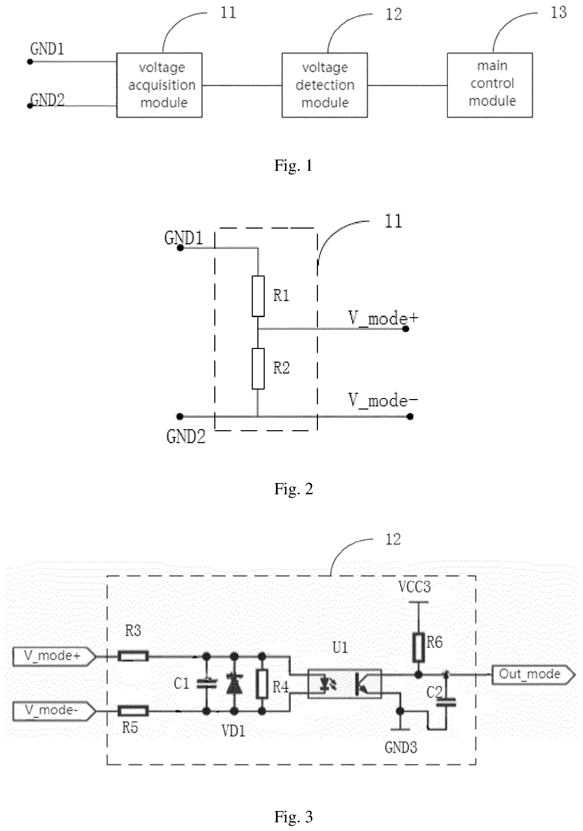

Referring to Fig. 1 to 7, it shows a lithium battery power supply connection relationship detection circuit provided by an embodiment of the present application. A first power supply DC1 and a second power supply DC2 are connected in series or in parallel to form a power supply system; the detection circuit is configured for detecting a series-parallel relationship between the first power supply DC1 and the second power supply DC2; and the series-parallel relationship between the first power supply DC1 and the second power supply DC2 is switchable;
the detection circuit comprises a voltage acquisition module 11, a voltage detection module 12 and a main control module 13;
a first input end of the voltage acquisition module 11 is connectable with a negative electrode GND1 of the first power supply DC1, a second input end of the voltage acquisition module 11 is connectable with a negative electrode GND2 of the second power supply DC2, and an output end of the voltage acquisition module 11 is connected with an input end of the voltage detection module 12;
an output end Out_mode of the voltage detection module 12 is connected with the main control module (13); and
the main control module 13 is configured for receiving a detection signal output by the output end Out_mode of the voltage detection module 12 and determining the series-parallel relationship between the first power supply DC1 and the second power supply DC2 based on the detection signal.

In the embodiment of the present application, both the first power supply DC1 and the second power supply DC2 are lithium battery power supplies, and the first power supply DC1 and the second power supply DC2 are connected in series or in parallel to form a power supply system. For example, the rated voltage of both power supplies is U; if two power supplies are connected in series, the output voltage of the power supply system is 2U; if two power supplies are connected in parallel, the output voltage of the power system is U.

Meanwhile, when the first power supply DC1 and the second power supply DC2 are connected in parallel, the negative electrodes (GND1 and GND2) of the two power supplies are connected, so the voltage difference between the negative electrodes (GND1 and GND2) of the two power supplies is very small; when the first power supply DC1 and the second power supply DC2 are connected in series, the voltage difference between the negative electrodes (GND1 and GND2) of the two power supplies is relatively large. Based on this, in the embodiment of the present application, the voltage acquisition module 11 obtains the voltage difference between the negative electrodes (GND1 and GND2) of two power supplies and matches it to a suitable voltage to send to the voltage detection module 12. The voltage detection module 12 generates a detection signal based on the voltage difference and sends it to the main control module 13. The main control module 13 determines the series-parallel relationship between the two power supplies based on the detection signal. The circuit structure is simple and the detection is fast.

For example, when the voltage difference between the negative electrode GND1 of the first power supply DC1 and the negative electrode GND2 of the second power supply DC2 is greater than a preset voltage, the detection signal is a first level, and the main control module 13 determines that the first power supply DC1 and the second power supply DC2 are connected in series. When the voltage difference between the negative electrode GND1 of the first power supply DC1 and the negative electrode GND2 of the second power supply DC2 is less than the preset voltage, the detection signal is a second level, and the main control module 13 can determine that the first power supply DC1 and the second power supply DC2 are in parallel.

Specifically, the first level may be low level, and the second level may be high level.

In one possible embodiment, referring to Fig. 2, the input end of the voltage detection module 12 may include: a first voltage input end V_mode+ and a second voltage input end V_mode-; the first voltage input end V_mode+ is connected with the output end of the voltage acquisition module 11, and the second voltage input end V_mode- is connected with the second input end of the voltage acquisition module 11;
the voltage acquisition module 11 may include a first resistor R1 and a second resistor R2;
a first end of the first resistor R1 is connected with the first input end of the voltage acquisition module 11, and a second end of the first resistor R1 is respectively connected with a first end of the second resistor R2 and the output end of the voltage acquisition module 11; and
a second end of the second resistor R2 is connected with the second input end of the voltage acquisition module 11.

In the embodiment of the present application, the first input end and the second input end of the voltage acquisition module 11 obtains the voltage difference between the negative electrodes (GND1 and GND2) of the two power supplies, and sends it to the voltage detection module 12 after voltage matching through voltage dividing of the first resistor R1 and the second resistor R2. The structure is simple, there are few devices, and the cost is low.

In one possible embodiment, referring to Fig. 3, the voltage detection module 12 may include an optical coupler U1, a third resistor R3, a fourth resistor R4, a fifth resistor R5 and a sixth resistor R6;
a positive input end of the optical coupler U1 is respectively connected with a first end of the third resistor R3 and a first end of the fourth resistor R4, a negative input end of the optical coupler U1 is respectively connected with a second end of the fourth resistor R4 and a first end of the fifth resistor R5, a positive output end of the optical coupler U1 is respectively connected with a first end of the sixth resistor R6 and the output end Out_mode of the voltage detection module 12, and a negative output end of the optical coupler U1 is grounded;
a second end of the third resistor R3 is connected with the first voltage input end V_mode+ of the voltage detection module 12;
a second end of the fifth resistor R5 is connected with the second voltage input end V_mode- of the voltage detection module 12; and
a second end of the sixth resistor R6 is connected with a DC power supply VCC3.

Optical couplers are devices that use light as a medium to transmit electrical signals. The signals are transmitted in a unidirectional manner, with complete electrical isolation between the input end and the output end. The output signals have no impact on the input end, strong anti-interference ability, stable operation, contactless, long service life, high transmission efficiency, and are widely used in switching circuits.

In the embodiment of the present application, the optical coupler U1 is used to generate the detection signal. When the first power supply DC1 and the second power supply DC2 are connected in parallel, the voltage difference between the negative electrodes (GND1 and GND2) of the two power supplies is small, the voltage difference between the positive input end and the negative input end of the optical coupler U1 is small, the optical coupler U1 is not conductive, and the voltage detection module 12 outputs a high level. When the first power supply DC1 and the second power supply DC2 are connected in series, the voltage difference between the negative electrodes (GND1 and GND2) of the two power supplies is relatively large, the optical coupler U1 is conductive, and the voltage detection module 12 outputs a low level, thereby realizing the detection of the series-parallel relationship between the two power supplies. The above circuit structure is simple, and the optical coupler U1 is isolated front and rear, with strong anti-interference ability and stable operation. The simplest circuit is used to realize the detection of the series-parallel relationship of the power supplies.

Meanwhile, in the embodiment of the present application, voltage matching is carried out through the voltage acquisition module 11, so that the obtained voltage difference meets the voltage requirements of the input ends of the optical coupler U1.

In one possible embodiment, referring to Fig. 3, the voltage detection module 12 may also include a zener diode VD1;
a cathode of the zener diode VD1 is connected with the positive input end of the optical coupler U1, and an anode of the zener diode VD1 is connected with the negative input end of the optical coupler U1.

In the embodiment of the present application, the zener diode VD1 is also installed to stabilize the voltage at the input ends of the optical coupler U1, avoiding the introduction of high voltage interference at the input ends of the optical coupler U1 and damaging it, effectively improving the stability and reliability of the circuit.

In one possible embodiment, referring to Fig. 3, the voltage detection module 12 may also include a first capacitor C1 and a second capacitor C2;
the first capacitor C1 is connected in parallel with the fourth resistor R4; and
a first end of the second capacitor C2 is connected with the positive output end of the optical coupler U1, and a second end of the second capacitor C2 is grounded.

The first capacitor C1 and the second capacitor C2 are used for filtering, improving the reliability of the circuit.

In the above embodiment, the main control module 13 may include a single-chip microcomputer, which determines whether the first power supply DC1 and the second power supply DC2 are connected in series or in parallel based on the detection signal. The details will not be repeated here.

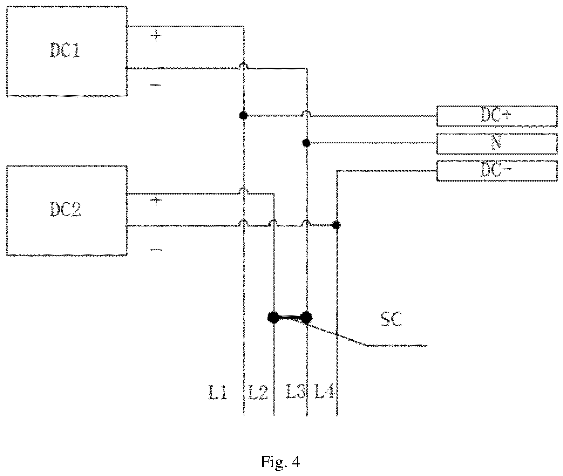

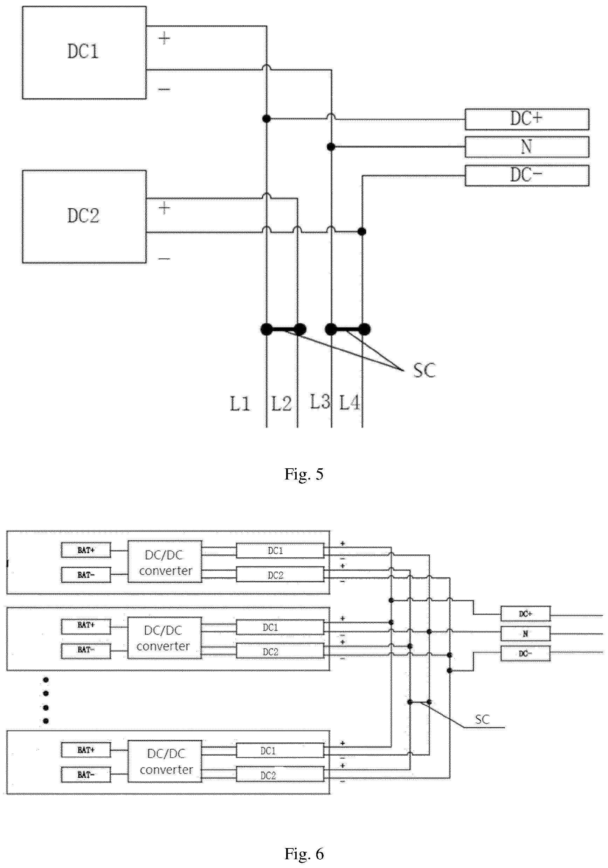

In one possible embodiment, referring to Fig. 4 and Fig. 5, the power supply system may also include two series-parallel short-circuit rows SC;
a positive electrode of the first power supply DC1 is connected with a positive output end DC+ of the power supply system, and the negative electrode GND1 of the first power supply DC1 is connected with a neutral end N of the power supply system;
a positive electrode of the second power supply DC2 is vacant, and the negative electrode GND2 of the second power supply DC2 is connected with a negative output end DC- of the power supply system; and
where one series-parallel short-circuit row SC is overlapped between the negative electrode GND1 of the first power supply DC1 and the positive electrode of the second power supply DC2, and the first power supply DC1 and the second power supply DC2 are connected in series; or
one series-parallel short-circuit row SC is overlapped between the positive electrode of the first power supply DC1 and the positive electrode of the second power supply DC2, the other series-parallel short-circuit row SC is overlapped between the negative electrode GND1 of the first power supply DC1 and the negative electrode GND2 of the second power supply DC2, and the first power supply DC1 and the second power supply DC2 are connected in parallel.

The power supply system in the embodiment of the present application is also equipped with two series-parallel short-circuit rows SC, which enable quick switching of the series-parallel relationship between the first power supply DC1 and the second power supply DC2. Referring to Fig. 4, the positive electrode of the second power supply DC2 is vacant, when one series-parallel short-circuit row SC is connected to the negative electrode GND1 of the first power supply DC1 and the positive electrode of the second power supply DC2, the negative electrode GND 1 of the first power supply DC 1 and the positive electrode of the second power supply DC2 are short circuited. The first power supply DC1 and the second power supply DC2 are connected in series, and the voltage of the two power supplies in series is output through the positive output end DC+ and the negative output end DC- of the power supply system.

Similarly, due to the vacancy of the positive electrode of the second power supply DC2, and the connection between the negative electrode GND1 of the first power supply DC1 and the neutral end N of the power supply system, referring to Fig. 5, one series-parallel short-circuit row SC may be used to short circuit the positive electrode of the first power supply DC 1 and the positive electrode of the second power supply DC2, and to short circuit the negative electrode GND1 of the first power supply DC1 and the negative electrode GND2 of the second power supply DC2 through the other series-parallel short-circuit row SC. The voltage of two power supplies in parallel is also output through the positive output end DC+ of the power supply system and the negative output end DC- of the power supply system.

In the embodiment of the present application, the fast switching of the series-parallel relationship between two power supplies can be achieved by only using two series-parallel short-circuit rows SC. There is no need to modify the wiring, and it is fast and simple, so that the power supply system can output different voltages to meet the needs of different application scenarios, and improve the adaptability of the power supply system.

Note that the neutral end N of the power supply system cannot be externally connected at this time.

In one possible embodiment, referring to Fig. 4 and Fig. 5, the power supply system may also include: a first connection line L1, a second connection line L2, a third connection line L3 and a fourth connection line L4;
the positive electrode of the first power supply DC1 is connected with the positive output end DC+ of the power supply system through the first connection line L1;
the positive electrode of the second power supply DC2 is connected with the second connection line L2;
the negative electrode GND1 of the first power supply DC1 is connected with the neutral end N of the power supply system through the third connection line L3;
the negative electrode GND2 of the second power supply DC2 is connected with the negative output end DC- of the power supply system through the fourth connection line L4; and
where one series-parallel short-circuit row SC is overlapped between the second connection line L2 and the third connection line L3, and the first power supply DC1 and the second power supply DC2 are connected in series; or
one series-parallel short-circuit row SC is overlapped between the first connection line L1 and the second connection line L2, the other series-parallel short-circuit row SC is overlapped between the third connection line L3 and the fourth connection line L4, and the first power supply DC1 and the second power supply DC2 are connected in parallel.

Specifically, in the embodiment of the present application, four connecting lines may be set to connect the electrodes of the power supplies to the ends of the power supply system, and the connecting terminals can be led out to facilitate the overlap of the series-parallel short-circuit rows SC.

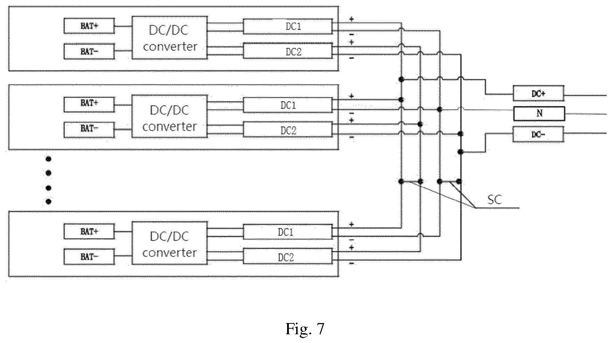

In one possible embodiment, referring to Fig. 6 and Fig. 7, a number of the first power supply DC1 is at least one, a number of the second power supply DC2 is at least one, and the number of the first power supply DC1 is the same as the number of the second power supply DC2;
the positive electrode of each first power supply DC1 is connected with the first connection line L1, and the negative electrode GND1 of each first power supply DC1 is connected with the third connection line L3;
the positive electrode of each second power supply DC2 is connected with the second connection line L2, and the negative electrode GND2 of each second power supply DC2 is connected with the fourth connection line L4; and
where one series-parallel short-circuit row SC is overlapped between the second connection line L2 and the third connection line L3, and each first power supply DC1 is connected in series with corresponding second power supply DC2, respectively; or
one series-parallel short-circuit row SC is overlapped between the first connection line L1 and the second connection line L2, the other series-parallel short-circuit row SC is overlapped between the third connection line L3 and the fourth connection line L4, and each first power supply DC1 is connected in parallel with corresponding second power supply DC2, respectively.

In the embodiment of the present application, both the number of the first power supply DC1 and the number of the second power supply DC2 may be multiple. Multiple first power supplies DC1 are connected in parallel, and multiple second power supplies DC2 are also connected in parallel. The parallel connection of multiple power supplies is achieved through four connecting lines (L1, L2, L3, and L4), and several series-parallel short-circuit rows SC are overlapped between the four connecting lines to achieve the series or parallel connection of the power supplies, achieving different voltage outputs, so that the power supply system can meet different application requirements.

In one possible embodiment, referring to Fig. 6 and Fig. 7, the first connection line L1, the second connection line L2, the third connection line L3 and the fourth connection line L4 are arranged side by side in sequence.

Specifically, the four connecting lines (L1, L2, L3, and L4) may be arranged side by side in sequence in order to facilitate the overlap of the series-parallel short-circuit rows SC, avoid overlapping across connecting lines, and meet insulation requirements. For example, referring to Fig. 6, when one series-parallel short-circuit row SC is overlapped on the middle two connecting lines, the first power supply DC1 and the second power supply DC2 are connected in series. Referring to Fig. 7, when two series-parallel short-circuit rows SC are respectively overlapped between the first connection line L1 and the second connection line L2, and between the third connection line L3 and the fourth connection line L4, the first power supply DC1 and the second power supply DC2 are connected in parallel, without cross connection lines overlap, which is convenient for wiring and does not cause short circuit faults, improving the safety of the power supply system.

Furthermore, referring to Fig. 6 and Fig. 7, the first power supply DC1 and the second power supply DC2 may be generated by the same lithium battery pack, which outputs two 240V circuits through a DC/DC converter as the first power supply DC1 and the second power supply DC2, respectively.

Specifically, the first power supply DC1 and second power supply DC2 may also be obtained by connecting different power supply modules (such as lithium battery packs) in series or in parallel. The connection relationship between each power supply module in the first power supply DC1 and the second power supply DC2 is not limited and may be different, as long as the output voltages of the two power supplies are the same.

The above embodiments are only used to illustrate the technical solution of the present application, not to limit it. Although the present application has been described in detail with reference to the aforementioned embodiments, ordinary technical personnel in this field should understand that they can still modify the technical solutions recorded in the aforementioned embodiments or equivalently replace some of the technical features. These modifications or substitutions do not separate the essence of the corresponding technical solutions from the spirit and scope of the technical solutions of each embodiment of the present application, and should be included in the scope of protection of the present application.

## Claims

1. A lithium battery power supply connection relation detection circuit, wherein a first power supply (DC1) and a second power supply (DC2) are connected in series or in parallel to form a power supply system; the detection circuit is configured for detecting a series-parallel relationship between the first power supply (DC1) and the second power supply (DC2); and the series-parallel relationship between the first power supply (DC1) and the second power supply (DC2) is switchable;
**characterized in that** the detection circuit comprises a voltage acquisition module (11), a voltage detection module (12) and a main control module (13);
a first input end of the voltage acquisition module (11) is connectable with a negative electrode (GND1) of the first power supply (DC1), a second input end of the voltage acquisition module (11) is connectable with a negative electrode (GND2) of the second power supply (DC2), and an output end of the voltage acquisition module (11) is connected with an input end of the voltage detection module (12);
an output end (Out_mode) of the voltage detection module (12) is connected with the main control module (13); and
the main control module (13) is configured for receiving a detection signal output by the output end (Out_mode) of the voltage detection module (12) and determining the series-parallel relationship between the first power supply (DC1) and the second power supply (DC2) based on the detection signal.

2. The detection circuit according to claim 1, wherein the input end of the voltage detection module (12) comprises a first voltage input end (V_mode+) and a second voltage input end (V_mode-); the first voltage input end (V_mode+) is connected with the output end of the voltage acquisition module (11), and the second voltage input end (V_mode-) is connected with the second input end of the voltage acquisition module (11);
the voltage acquisition module (11) comprises a first resistor (R1) and a second resistor (R2);
a first end of the first resistor (R1) is connected with the first input end of the voltage acquisition module (11), and a second end of the first resistor (R1) is respectively connected with a first end of the second resistor (R2) and the output end of the voltage acquisition module (11); and
a second end of the second resistor (R2) is connected with the second input end of the voltage acquisition module (11).

3. The detection circuit according to claim 2, wherein the voltage detection module (12) comprises an optical coupler (U1), a third resistor (R3), a fourth resistor (R4), a fifth resistor (R5) and a sixth resistor (R6);
a positive input end of the optical coupler (U1) is respectively connected with a first end of the third resistor (R3) and a first end of the fourth resistor (R4), a negative input end of the optical coupler (U1) is respectively connected with a second end of the fourth resistor (R4) and a first end of the fifth resistor (R5), a positive output end of the optical coupler (U1) is respectively connected with a first end of the sixth resistor (R6) and the output end (Out_mode) of the voltage detection module (12), and a negative output end of the optical coupler (U1) is grounded;
a second end of the third resistor (R3) is connected with the first voltage input end (V_mode+) of the voltage detection module (12);
a second end of the fifth resistor (R5) is connected with the second voltage input end (V_mode-) of the voltage detection module (12); and
a second end of the sixth resistor (R6) is connected with a DC power supply (VCC3).

4. The detection circuit according to claim 3, wherein the voltage detection module (12) further comprises a zener diode (VD1);
a cathode of the zener diode (VD1) is connected with the positive input end of the optical coupler (U1), and an anode of the zener diode (VD1) is connected with the negative input end of the optical coupler (U1).

5. The detection circuit according to claim 3, wherein the voltage detection module (12) further comprises a first capacitor (C1) and a second capacitor (C2);
the first capacitor (C1) is connected in parallel with the fourth resistor (R4); and
a first end of the second capacitor (C2) is connected with the positive output end of the optical coupler (U1), and a second end of the second capacitor (C2) is grounded.

6. The detection circuit according to anyone of claims 1 to 5, wherein the power supply system further comprises two series-parallel short-circuit rows (SC);
a positive electrode of the first power supply (DC1) is connected with a positive output end (DC+) of the power supply system, and the negative electrode (GND1) of the first power supply (DC1) is connected with a neutral end (N) of the power supply system;
a positive electrode of the second power supply (DC2) is vacant, and the negative electrode (GND2) of the second power supply (DC2) is connected with a negative output end (DC-) of the power supply system; and
wherein one series-parallel short-circuit row (SC) is overlapped between the negative electrode (GND1) of the first power supply (DC1) and the positive electrode of the second power supply (DC2), and the first power supply (DC1) and the second power supply (DC2) are connected in series; or
one series-parallel short-circuit row (SC) is overlapped between the positive electrode of the first power supply (DC1) and the positive electrode of the second power supply (DC2), the other series-parallel short-circuit row (SC) is overlapped between the negative electrode (GND1) of the first power supply (DC1) and the negative electrode (GND2) of the second power supply (DC2), and the first power supply (DC1) and the second power supply (DC2) are connected in parallel.

7. The detection circuit according to claim 6, wherein the power supply system further comprises a first connection line (L1), a second connection line (L2), a third connection line (L3) and a fourth connection line (L4);
the positive electrode of the first power supply (DC1) is connected with the positive output end (DC+) of the power supply system through the first connection line (L1);
the positive electrode of the second power supply (DC2) is connected with the second connection line (L2);
the negative electrode (GND1) of the first power supply (DC1) is connected with the neutral end (N) of the power supply system through the third connection line (L3);
the negative electrode (GND2) of the second power supply (DC2) is connected with the negative output end (DC-) of the power supply system through the fourth connection line (L4); and
wherein one series-parallel short-circuit row (SC) is overlapped between the second connection line (L2) and the third connection line (L3), and the first power supply (DC1) and the second power supply (DC2) are connected in series; or
one series-parallel short-circuit row (SC) is overlapped between the first connection line (L1) and the second connection line (L2), the other series-parallel short-circuit row (SC) is overlapped between the third connection line (L3) and the fourth connection line (L4), and the first power supply (DC1) and the second power supply (DC2) are connected in parallel.

8. The detection circuit according to claim 7, wherein a number of the first power supply (DC1) is at least one, a number of the second power supply (DC2) is at least one, and the number of the first power supply (DC1) is the same as the number of the second power supply (DC2);
the positive electrode of each first power supply (DC1) is connected with the first connection line (L1), and the negative electrode (GND1) of each first power supply (DC1) is connected with the third connection line (L3);
the positive electrode of each second power supply (DC2) is connected with the second connection line (L2), and the negative electrode (GND2) of each second power supply (DC2) is connected with the fourth connection line (L4); and
wherein one series-parallel short-circuit row (SC) is overlapped between the second connection line (L2) and the third connection line (L3), and each first power supply (DC1) is connected in series with corresponding second power supply (DC2), respectively; or
one series-parallel short-circuit row (SC) is overlapped between the first connection line (L1) and the second connection line (L2), the other series-parallel short-circuit row (SC) is overlapped between the third connection line (L3) and the fourth connection line (L4), and each first power supply (DC1) is connected in parallel with corresponding second power supply (DC2), respectively.

9. The detection circuit according to claim 8, wherein the first connection line (L1), the second connection line (L2), the third connection line (L3) and the fourth connection line (L4) are arranged side by side in sequence.
